# EUROPÄISCHE PATENTANMELDUNG

(11) **EP 0 687 012 A2**
(43) Veröffentlichungstag der Anmeldung: **13.12.1995**
(21) Anmeldenummer: 95201440.5
(22) Anmeldetag: 01.06.1995
(51) Int. Cl.: H01L 29/08, H01L 29/74

(54) **Anodenseitige Shortstruktur für asymmetrische Thyristoren**

(30) Priorität: 10.06.1994 DE 4420252
(71) Anmelder: ABB Management AG, CH-5401 Baden (CH)
(72) Erfinder: Streit, Peter, Dr., CH-8967 Widen (CH)

(57) **Zusammenfassung**

Ein erfindungsgemässer Thyristor umfasst zwischen einer Anode (1) und einer Kathode (2) in einem Halbleitersubstrat (3) eine Schichtenfolge mit einer n-Emitterschicht (4), einer p-Basisschicht (5), einer n-Basisschicht (6) und einer p-Emitterschicht (7). Die p-Emitterschicht (7) ist von Anodenkurzschlussgebieten (8) durchbrochen und wird dadurch in Abschnitte unterteilt. Dabei schliessen die Anodenkurzschlüsse (8) die n-Basisschicht (6) mit der Anode (1) kurz. Zwischen den Anodenkurzschlüsse (8) und der p-Emitterschicht (7) ist eine p-Sperrschicht (9), auch p-soft Schicht genannt, angeordnet. Nach der Erfindung weist diese p-Sperrschicht (9) Lücken (12) auf, in welchen die n-Basis (6) entweder direkt oder über ein Anodenkurzschluss (8) mit der Anode (1) kontaktiert ist.

## Beschreibung

### Technisches Gebiet

Die Erfindung bezieht sich auf das Gebiet Leistungshalbleiterelektronik.

Sie geht aus von einem Thyristor nach dem Oberbegriff des ersten Anspruchs.

### Stand der Technik

Ein solcher Thyristor wird schon in der Europäischen Patentanmeldung EP 0 327 901 A1 beschrieben.

Es handelt sich dabei um eine asymmetrisch blockierenden Thyristor, das heisst um einen Thyristor, der nur einen vorwärts blockierenden und einen vorwärts leitenden Betriebszustand aufweist. Ein rückwärts sperrender Zustand ist nicht gefordert, dagegen wird der notwendige rückwärts leitende Zustand mittels einer diskreten oder integrierten antiparallelen Diode realisiert.

Derartige asymmetrisch blockierende Elemente haben wegen der fehlenden Rückwärts-Sperrfähigkeit einige zusätzliche designmässige Freiheitsgrade, die eine andere Optimierung erlauben. Die wichtigsten Verbesserungsmöglichkeiten sind:
a) das Einbringen einer Stopschicht zur dünneren Auslegung des Wafers.
b) das Einbringen einer anodenseitigen Vershortung zur Verbesserung der dynamischen Eigenschaften.

Beide Massnahmen haben grosses Verbesserungspotential, die Stopschicht primär bei sehr hohen Spannungen (z.B. über 3 kV), die Anodenvershortung primär bei abschaltbaren Bauelementen hoher Leistung, sog. GTOs, da bei diesen Elementen die Ausräumung der anodenseitigen Bereiche von Ladungsträgern deutlich erleichtert und damit der Tailstrom reduziert wird.

Beide Massnahmen haben jedoch auch gewisse Nachteile bezüglich Einschalten und Durchlasszustand, da die Wirkung des anodenseitigen Emitters beeinflusst wird. Bei der Stopschicht ist dieser Einfluss nur sehr schwach und graduell, bei der Vershortung viel stärker, da eine eigentliche Zündschwelle eingeführt wird. Am stärksten zündhemmend wirkt eine Kombination beider Massnahmen im selben Element.

Interessant ist, dass sich diese gegenläufige Beeinflussung von Zündung und Abschaltoptimierung nicht bloss in Bezug auf das Vorhandensein einer Anoden-Vershortung sondern auch bezüglich der Auslegung dieser Vershortung äussert: Die Optimierung des Abschaltverhaltens erfordert an sich eine möglichst feinmaschige Vershortung, bei der Emitter- und Shortbereiche möglichst gleichmässig auf der ganzen aktiven Elementfläche verteilt sind, während die Zündbarkeit in dem Masse leidet, als die minimale Emitterbreite herabgesetzt wird.

Die Auslegung der Struktur einer herkömmlichen vershorteten Anode ist demnach ein Optimierungsproblem, bei dem es darum geht, die Abschalt-Eigenschaften bestmöglich zu beeinflussen, ohne dabei die Zündfreudigkeit der Elemente in einer durch Spezifikationen verbotenen resp. durch Gate-Units nicht mehr beherrschbaren Weise zu verschlechtern.

Die Shortwirkung beim Abschalten ist vor allem bei hoher Injektion in der n-Basis ausschlaggebend, während für die Zündbarkeit das Verhalten des Anodenemitters bei schwacher bis mittlerer Injektion wichtig ist. In der genannten Patentanmeldung EP 0 327 901 A1 wird deshalb versucht, der eigentlichen Emitterstruktur, wie sie bei Hochinjektion wirksam ist, andere Strukturen schwächerer Dotierungskonzentration vorzulagern, welche bei niedriger Injektion die Eigenschaften deutlich beeinflussen. Zu diesem Zweck wird den Anodenkurzschlüssen eine niedrig dotierte p-Sperrschicht vorgelagert.

Dies hat zur Folge, dass die für die vershortete Anode typische Zündschwelle, d.h. die definierte Anodenstromdichte, ab welcher Löcheremission von der Anode her erfolgen kann, praktisch unwirksam wird. Die Elemente sind damit in der Regel sehr viel zündfreudiger. Diese Massnahme weist jedoch auch nachteilige Nebenwirkungen auf:
- Bei GTOs, welche keine kathodenseitige Vershortung haben, fällt mit der niedrig dotierten Sperrschicht auch die anodenseitige Definition einer Zündschwelle dahin, d.h. die Elemente können speziell bei erhöhten Temperaturen derart zündfreudig werden, dass die Spannungsfestigkeit (dV/dt-Festigkeit) gefährdet ist.
- Eine ganzflächige Sperrschicht verstärkt bereits die Leckströme im Element.
- Die Sperrschicht führt zu einem nicht wirklich definierten Rückwärts-Spannungsverhalten, da der zusätzlich eingebrachte pn-Übergang eine gewisse Sperrfähigkeit hat und danach bei schlecht definierter Spannung durchbricht.

### Darstellung der Erfindung

Aufgabe der vorliegenden Erfindung ist es deshalb, einen Thyristor anzugeben, welcher auch bei erhöhten Temperaturen eine genügende Spannungsfestigkeit aufweist und bei welchem die oben erwähnten Nachteile vermieden werden. Insbesondere soll der erfindungsgemässe Thyristor eine gute Shortwirkung aufweisen bei dennoch guter Zündbarkeit.

Diese Aufgabe wird durch die Merkmale des ersten Anspruchs gelöst.

Kern der Erfindung ist es also, dass die Wirkungen von Anodenkurzschlüssen und Sperrschicht weitgehend entkoppelt werden durch eine laterale Strukturierung der Sperrschicht. Dadurch gelingt es, sowohl die beiden oben erwähnten Nachteile zu eliminieren als auch eine neue Zündschwelle zu definieren, die nicht direkt mit der Short-Wirksamkeit beim Abschalten gekoppelt ist.

Zu diesem Zweck weist die Sperrschicht Lücken auf, in welchen die n-Basis direkt oder über ein Anodenkurzschlussgebiet mit der Anode kontaktiert ist.

In einem Ausführungsbeispiel wird der p-Sperrschicht zusätzlich eine durchgehende n-Stopschicht vorgelagert. Die Lücke sind insbesondere entweder streifen- oder löcherförmig ausgebildet.

Weitere Ausführungsbeispiele ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Einen Ausschnitt eines erfindungsgemässen Thyristors;
- **Fig. 2**: Einen Ausschnitt eines erfindungsgemässen Thyristors in einer Variante mit zusätzlicher Stopschicht;
- **Fig. 3, 4**: Weitere Schnitte durch einen erfindungsgemässen Thyristor;
- **Fig. 5, 6**: Schematische Aufsichten auf die erfindungsgemäss p-Sperrschicht.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

Charakteristisch für eine herkömmlich vershorteten Anodenstruktur ist, dass die Shortbereiche direkt (ohne Übergang) mit der n-Basis verbunden sind. Bei kleiner Stromdichte ist anschaulich, dass die Ladungsträger die Potentialbarriere des pn-Überganges zum p+ Emitter meiden und daher direkt in die Shorts abfliessen, sodass es an der Anode vorerst zu keiner Löcherinjektion kommen kann und der Thyristor nicht latcht sondern bloss als npn-Transistor leitet. Erst bei genügend grossen Lateralströmen vor den Emitterbereichen gibt es eine Zündschwelle, ab welcher der Spannungsabfall für Löcherinjektion ausreicht und damit ein bipolarer Leitungszustand entsteht. In der Sprache des Zwei-Transistor-Ersatzschaltbildes wurde das heissen, dass erst ab dieser Zündschwelle der pnp-Transistor eine von Null verschiedene Stromverstärkung Alpha (Basisgrundschaltung) hat.

Bei zunehmender Stromdichte nimmt dieses Alpha (pnp) dann relativ steil zu, um einem Sättigungswert zuzustreben, der seinerseits nun im wesentlichen durch das Flächenverhältnis Emitter zu Gesamtanode limitiert ist, von der Feinheit der Struktur aber kaum abhängt. Diese Argumentation legt also nahe, dass es gelingt, mittels geeigneter Shortstruktur der Anode zwei für das elektrische Verhalten wesentliche Parameter innerhalb gewisser Grenzen unabhängig voneinander einzustellen:
a) Eine Schwell-Stromdichte, ab welcher Löcherinjektion von der Anode einsetzt, und
b) ein Sättigungswert von Alpha (pnp), der auch im Hochinjektionsfall nicht überstiegen wird.

Bei einer Struktur mit vorgelagerter, rel. niedrig dotierter p-Sperrschicht (im folgenden auch "p-soft-Schicht" genannt) wie in der EP 0 327 901 A1 wird das Entstehen der Lateralströme in der n-Basis weitgehend verhindert. Damit wird die Zündschwelle unwirksam. Falls jedoch die Konzentrationen der p-soft-Schicht nicht gross genug sind, um ihrerseits Lateralströme zu führen oder in die n-Basis zu injizieren, so bleibt das Flächenverhältnis der dahinter liegenden Emitter- und Shortstruktur bestimmend für den Hochinjektionsfall. Damit ist die positive Wirkung der Vershortung bezüglich Schaltverhalten weiterhin in annähernd gleichem Umfang gewährleistet. Oder im Sinn der EP 0 327 901 A1 wird es nun möglich, die Anodenvershortung deutlich feinmaschiger und damit beim Abschalten wirksamer auszulegen, ohne dabei auf die Erfordernisse an die Zündfreudigkeit der Elemente weiter Rücksicht zu nehmen. Andererseits ist die Anwendung einer p-Sperrschicht an die bereits eingangs dargelegten Nachteile gebunden, und diese lassen sich durch die Erfindung wie folgt eliminieren:

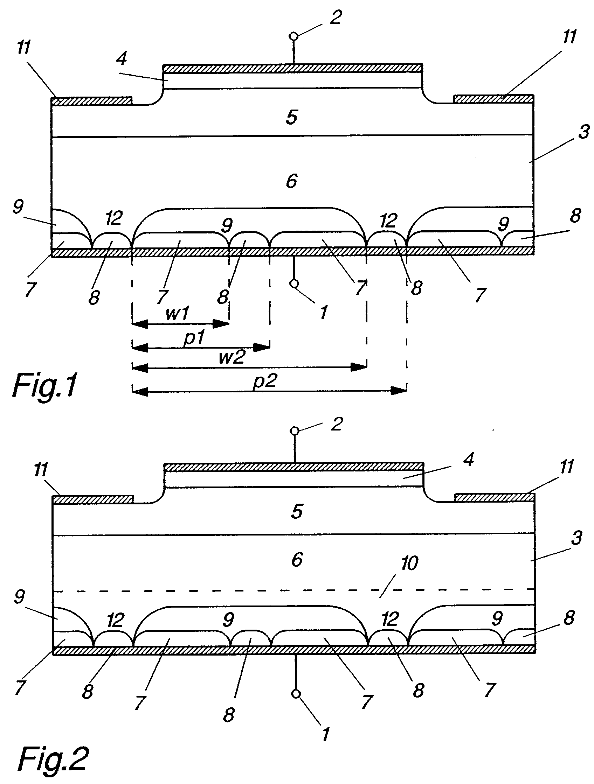

**Figur 1** zeigt eine erste Ausführungsform der vorliegenden Erfindung. Dargestellt ist eine lateral ebenfalls strukturierte p-Sperrschicht (9), wobei in diesem einfachen Beispiel beide Strukturen in derselben Ebene ihre kleinsten Dimensionen aufweisen. Die herkömmliche Emitterstruktur (7) ist durch die Parameter w1 und p1 charakterisiert, während die p-soft Sperrschichtstruktur (9) die analogen aber grösser gewählten Parameter w2 und p2 aufweist. Wichtig ist in diesem einfachen Fall, dass p2 ein Mehrfaches von p1 ist und die Shorts (8) im Raster 2 mit jenen im Raster 1 zusammenfallen. Bei dieser Struktur ist einsichtig, dass w2 als Breite der p-Soft-Struktur (9) (neben der Leitfähigkeit der n-Basis) die Zündschwelle analog wie die Breite w des p-Emitters eines GTOs nach dem Stand der Technik bestimmt. Damit kann also eine durch die Struktur definierte Zündschwelle weiterhin realisiert werden, ohne dass die eigentliche Emitterstruktur (7) grob und unwirksam gemacht werden muss.

Ebenso klar ist, dass diese Doppelstruktur wegen der zusammenfallenden Shorts (8) keine parasitäre Rückwärts-Sperrfähigkeit aufweist und dass die kleinen Sperrströme im Element ebenfalls ungehindert in die Shorts (8) abfliessen und daher nicht durch den pnp-Transistor weiter verstärkt werden. Damit sind alle eingangs erwähnten Nachteile einer konventionellen p-Sperrschicht (9) behoben.

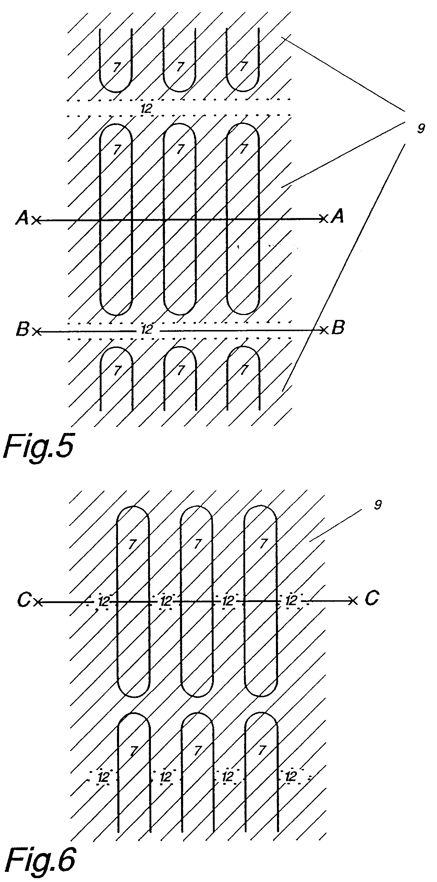

Ein erfindungsgemässer Thyristor umfasst also zwischen einer Anode (1) und einer Kathode (2) in einem Halbleitersubstrat (3) eine Schichtenfolge mit einer n-Emitterschicht (4), einer p-Basisschicht (5), einer n-Basisschicht (6) und einer p-Emitterschicht (7). Die p-Emitterschicht (7) ist von Anodenkurzschlussgebieten (8) durchbrochen und wird dadurch in Abschnitte unterteilt. Dabei schliessen die Anodenkurzschlüsse (8) die n-Basisschicht (6) mit der Anode (1) kurz. Zwischen den Anodenkurzschlüsse (8) und der p-Emitterschicht (7) ist eine p-Sperrschicht (9), auch p-soft Schicht genannt, angeordnet. Nach der Erfindung ist auch diese p-Sperrschicht (9) in Abschnitte unterteilt, welche auf beiden Seite durch Anodenkurzschlussgebiete (8) begrenzt werden. Die Breite der Abschnitte der p-Sperrschicht (9) wird nun mindestens doppelt so gross gewählt wie diejenige der Abschnitte der p-Emitterschicht (7). Die p-Sperrschicht (9) weist also Lücken (12) auf, in welchen die n-Basis (6) entweder direkt oder über einen Anodenkurzschluss (8) mit der Anode (1) kontaktiert ist. Sieht man sich eine derartige Struktur der p-Sperrschicht (9) von oben an, so ergibt sich beispielsweise eine Aufsicht wie in Figur 6. Zu beachten ist, dass die Anodenkurzschlussgebiete (8) nicht dargestellt sind und die Emittergebiete (7) gleich breit gewählt sind wie die Lücken (12). Schneidet man die Figur 6 entlang der Linie C-C, so ergibt sich im wesentlichen Figur 1.

**Figur 2** zeigt eine ähnliche Struktur wie Figur 1, hier ist jedoch der p-soft-Struktur (9) eine weitere diffundierte n-Stopschicht (10) vorgelagert, wie sie in der Einleitung als für asymmetrische Elemente typisch beschrieben wurde: die Stopschicht (10). Solche Stopschichten (10) haben eine gegenüber der n-Basis (6) merklich erhöhte Donatorkonzentration, damit eine Reduktion der Elementdicke möglich wird. Damit steigt auch die Flächenleitfähigkeit und folglich die Short-Wirksamkeit in ungewolltem Mass. Es ist daher kaum möglich, herkömmliche Short-Strukturen (8) mit Stopschichten (10) zu kombinieren, da entweder unzündbare Elemente resultieren oder die Strukturen derart grob werden, dass sich beim Abschalten keine homogene Wirkung einstellen kann.

Diese Schwierigkeit ist mit obiger p-Sperrschicht (9) stark entschärft, da es nun möglich ist, diese sehr viel grossflächiger anzulegen, ohne dass die Emitterstruktur (7) unwirksam wird. Eine gewisse Inhomogenität der Zündung ist viel eher zulässig, da hier die laterale Plasmaausbreitung innerhalb der einzelnen Kathoden-Emitterbereiche (4) sehr schnell zu homogener Stromverteilung führt.

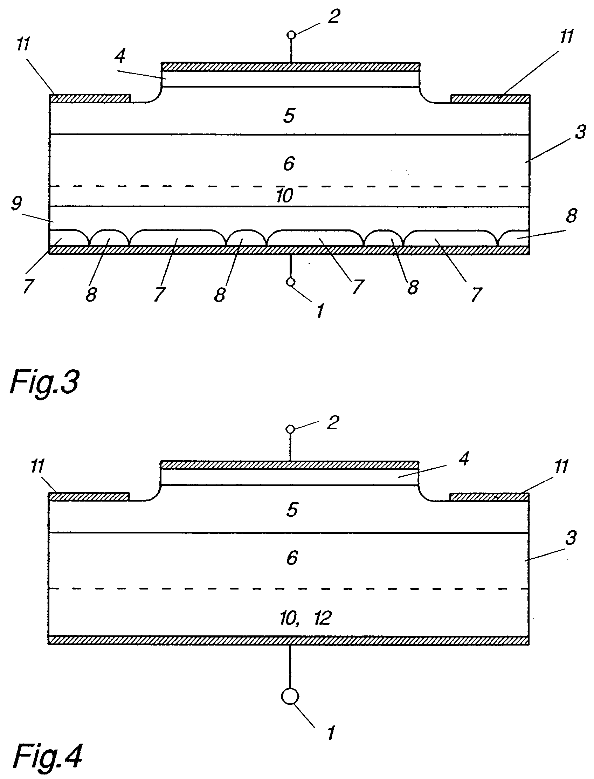

Ganz allgemein können die Lücken (12) z.B. streifenförmig, wie in Figur 5, oder löcherförmig, wie in Figur 6, ausgeführt sein. Werden zudem fingerförmige p-Emittergebiete (7) vorgesehen, so können die löcherförmigen Lücken (12) entweder an den Enden oder im wesentlichen in der Mitte angeordnet sein. Aus diese Weise erhält man entweder zündfreudige Fingermitten oder Fingerenden. Weiterhin können die streifenförmigen Lücken (12) entweder parallel oder rechtwinklig zu den p-Emittergebieten (7) angeordnet sein. Bei einer rechtwinkligen Anordnung, z.B. wie in Figur 5, ergeben sich die Schnittbilder der Figuren 3 und 4. Figur 3 entspricht einem Schnitt entlang der Linie A-A, Figur entlang B-B.

Insgesamt ergibt sich mit der erfindungsgemässen Struktur ein Thyristor, bei welchem die Wirkung von Anodenkurzschlüssen (8) und einer Sperrschicht (9) weitgehend entkoppelt werden können. Damit können beide Massnahmen für sich optimiert werden, so dass ihre Vorteile voll zum Tragen kommen.

### Bezeichnungsliste

- 1: Anode
- 2: Kathode
- 3: Halbleitersubstrat
- 4: n-Emitterschicht
- 5: p-Basisschicht
- 6: n-Basisschicht
- 7: p-Emitterschicht
- 8: Anodenkurzschlüsse
- 9: p-Sperrschicht
- 10: Stopschicht
- 11: Gate
- 12: Lücke in der p-Sperrschicht

## Patentansprüche

1. Abschaltbarer, asymmetrisch blockierender Thyristor mit einer Anode (1) und einer Kathode (2) umfassend
a) zwischen der Anode (1) und der Kathode (2) in einem Halbleitersubstrat (3) eine Schichtenfolge einer n-Emitterschicht (4), einer p-Basisschicht (5), einer n-Basisschicht (6) und einer p-Emitterschicht (7), wobei
b) die p-Emitterschicht (7) von Anodenkurzschlüssen (8) durchbrochen und
c) zwischen den Anodenkurzschlüssen (8) bzw. der p-Emitterschicht (7) eine p-Sperrschicht (9) angeordnet ist,
dadurch gekennzeichnet, dass
d) die p-Sperrschicht (9) Lücken (12) aufweist, in welchen die n-Basis (6) direkt oder über ein Anodenkurzschluss (8) mit der Anode (1) kontaktiert ist.

2. Thyristor nach Anspruch 1, dadurch gekennzeichnet, dass zwischen der n-Basis (6) und der p-Sperrschicht (9) eine ganzflächige n-Stopschicht (10) angeordnet ist.

3. Thyristor nach Anspruch 1 oder 2, dadurch gekennzeichnet, dass die Lücken (12) streifenförmig ausgebildet sind.

4. Thyristor nach Anspruch 3, dadurch gekennzeichnet, dass der Abstand zwischen zwei streifenförmigen Lücken (12) mindestens doppelt so gross ist wie der Abstand zwei Anodenkurzschlüsse (8).

5. Thyristor nach Anspruch 1 oder 2, dadurch gekennzeichnet, dass die Lücken (12) als Löcher in der p-Sperrschicht (9) ausgebildet sind.

6. Thyristor nach Anspruch 5, dadurch gekennzeichnet, dass die p-Emitterschicht (7) in fingerförmige Abschnitte unterteilt ist und die löcherförmige Lücken (12) im wesentlichen in der Mitte der Finger angeordnet sind.

7. Thyristor nach Anspruch 5, dadurch gekennzeichnet, dass die löcherförmigen Lücken (12) an den Enden der Finger angeordnet sind.
